# EUROPÄISCHE PATENTSCHRIFT

(11) **EP 3 642 069 B1**
(45) Veröffentlichungstag und Bekanntmachung des Hinweises auf die Patenterteilung: **21.04.2021**
(21) Anmeldenummer: 18733226.7
(22) Anmeldetag: 19.06.2018
(51) Int. Cl.: B60K 37/06, E05F 15/695, H03K 17/96

(54) **SCHALTVORRICHTUNG ZUM SCHALTEN VON ANTRIEBSORGANEN IN EINEM KRAFTFAHRZEUG**
SWITCHING DEVICE FOR SWITCHING DRIVE ELEMENTS IN A MOTOR VEHICLE
DISPOSITIF DE COMMUTATION POUR LA COMMUTATION D'ORGANES D'ENTRAÎNEMENT DANS UN VÉHICULE À MOTEUR

(30) Priorität: 21.06.2017 DE 102017005846
(43) Veröffentlichungstag der Anmeldung: 29.04.2020
(73) Patentinhaber: KOSTAL Automobil Elektrik GmbH & Co. KG, 58513 Lüdenscheid (DE)
(72) Erfinder: BLECKMANN, Michael, 58239 Schwerte-Ergste (DE); BORGMANN, Uwe, 45665 Recklinghausen (DE)
(74) Vertreter: Kerkmann, Detlef
(86) Internationale Anmeldenummer: PCT/EP2018/066204
(87) Internationale Veröffentlichungsnummer: WO 2018/234281

(56) Entgegenhaltungen:
- EP-A2- 1 978 535
- US-A1- 2006 144 680
- US-A1- 2013 187 889
- US-A1- 2014 069 015

## Beschreibung

Die Erfindung betrifft eine Schaltvorrichtung zum Schalten von Antriebsorganen in einem Kraftfahrzeug, aufweisend mehrere erste Schaltelemente, die an einer ersten Gehäusefläche angeordnet sind, und durch die zu betätigende Antriebsorgane ausgewählt werden können, und aufweisend mindestens ein, an der ersten Gehäusefläche oder an einer zweiten Gehäusefläche angeordnetes zweites Schaltelement, welches die Funktion des durch ein erstes Schaltelement ausgewählten Antriebsorgans beeinflusst, wobei die ersten Schaltelemente durch Finger einer Person betätigbar sind, und wobei das mindestens eine zweite Schaltelement mit einer Handfläche, einem Handballen oder einem Daumen betätigbar ist, wobei die ersten Schaltelemente und das mindestens eine zweite Schaltelement durch schaltkontaktlose Berührflächensensoren ausgebildet sind, und wobei das Einschalten eines Antriebsorgans durch die Betätigung eines der ersten Schaltelemente, die Betätigung eines des mindestens einen zweiten Schaltelements erfordert.

Eine derartige Schaltvorrichtung ist in der europäischen Patentanmeldung EP 1 978 535 A2 beschrieben.

Eine weitere Schaltvorrichtung ist aus der deutschen Patentschrift DE 195 07 952 C2 bekannt. Durch zwei erste Schaltelemente, die eine Bedienperson mit den Fingern bedienen kann, werden Antriebsorgane, beispielsweise rechte und linke Fensterheber in einem Kraftfahrzeug, ausgewählt und betätigt. Ein zweites, optional zu betätigendes Schaltelement ermöglicht darüber hinaus eine Umschaltung der zu betätigenden Antriebsorgane, so dass beispielsweise statt der vorderen Fensterheber danach die hinteren Fensterheber mittels der ersten Schaltelemente betätigbar sind. Das zweite Schaltelement ist in einer ersten vorgeschlagenen Ausführungsform an der gleichen Fläche angeordnet wie die ersten Schaltelemente und mit der Handfläche oder dem Handballen betätigbar. In einer zweiten vorgeschlagenen Ausführungsform ist das zweite Schaltelement an einer seitlichen Gehäusefläche angeordnet und wird mit dem Daumen betätigt. Sowohl die erste Schaltelemente als auch das zweite Schaltelement sind hier als mechanische Schalter beschrieben. Bei mechanischen Schaltelementen stellen aufgrund der relativ hohen Auslösekraftschwellen ungewollte Betätigungen durch versehentliche Berührungen im Allgemeinen kein besonderes Problem dar.

Die Aussage, dass bestimmte Schaltelemente "mit Finger, Handballen oder Daumen betätigbar" sind, soll hierbei nicht aussagen, dass Funktionen dieser Schaltelemente ausschließlich durch diese Körperteile ausgelöst werden können, sondern dass bei einer regulären Verwendung der Schaltvorrichtung, zur Betätigung der Schaltelemente genau die jeweils genannten Körperteile vorgesehen und auch zweckmäßig einsetzbar sind.

In modernen Kraftfahrzeugen ändert sich die Ausgestaltung des Innenraums gegenüber früheren Formgebungen ständig. Einzelne Funktions- oder Formelemente werden zusammengefasst, Fugen und Höhensprünge werden reduziert und Beleuchtungen und Funktionen sind nicht immer sichtbar. Sensorisches Schalten über Berühr- oder Kraftsensoren bietet die Möglichkeit, den Anforderungen eines modernen Designs gerecht zu werden, und in vielen Bereichen ist dieses heute bereits umgesetzt.

Bei Bedienelementen für Fenster und Schiebedächer erschwert die amerikanische FMVSS Norm 118 eine Umsetzung. Bei diesen Bedienelementen darf laut Norm ein unbeabsichtigtes Schließen des Fensters oder des Daches nicht möglich sein.

Bei Schaltvorrichtungen, die auf einer Berührungssensorik beruhen, stellen durch versehentliche Berührungen unerwünscht ausgelöste Schaltfunktionen ein kritisches Problem dar.

Die Aufgabe der Erfindung war es, eine Schaltvorrichtung für Fenster oder Schiebedächer in einem Kraftfahrzeug zu schaffen, das eine versehentliche sicherheitskritische Betätigung eines Antriebsorgans sicher verhindert.

Erfindungsgemäß wird diese Aufgabe dadurch gelöst, dass das Einschalten eines Antriebsorgans durch die Betätigung eines der ersten Schaltelemente, die gleichzeitige Betätigung eines des mindestens einen zweiten Schaltelements erfordert.

Grundsätzlich wird damit vorgeschlagen, dass zur Aktivierung einer Funktion zumindest zeitweise Schaltelemente aus zwei Sensorbereichen gleichzeitig betätigt werden müssen. Durch die Betätigung eines zweiten Schaltelements, etwa durch Auflegen des Handballens auf einen definierten Teil der Armauflage in der Tür des Kraftfahrzeugs oder durch Auflage des Daumens auf eine seitliche Fläche der Armauflage kann eine so die Freischaltung einer Fensterheberfunktion erfolgen, die über die ersten Schaltelemente ausgewählt wurde.

Eine besonders vorteilhafte Möglichkeit ist die Aufteilung von Fensterheberfunktionen auf zwei Sensorbereiche. So kann zum Beispiel die Wahl des/der zu betätigenden Fenster/s an einer oberen Gehäusefläche und die Wahl der gewünschten Laufrichtung an einer seitlichen Gehäusefläche getroffen werden. Hierdurch kann die Anzahl der auf der oberen Gehäusefläche benötigten ersten Schaltelemente halbiert werden.

Aus den Dokumenten US 2013/0187889 A1 und US 2006/0144680 A1 sind ebenfalls Schaltvorrichtungen zum Schalten von Antriebsorganen in einem Kraftfahrzeug bekannt. Diese Druckschriften offenbaren nicht den Aspekt der gleichzeitigen Betätigung eines ersten und eines zweiten Schaltelements.

Das Dokument US 2014/0069015 A1 offenbart den Aspekt einer gleichzeitigen Betätigung eines ersten und eines zweiten Schaltelements. Diese Druckschrift offenbart aber nicht, dass zu betätigende Antriebsorgane durch mehrere erste Schaltelemente ausgewählt werden können.

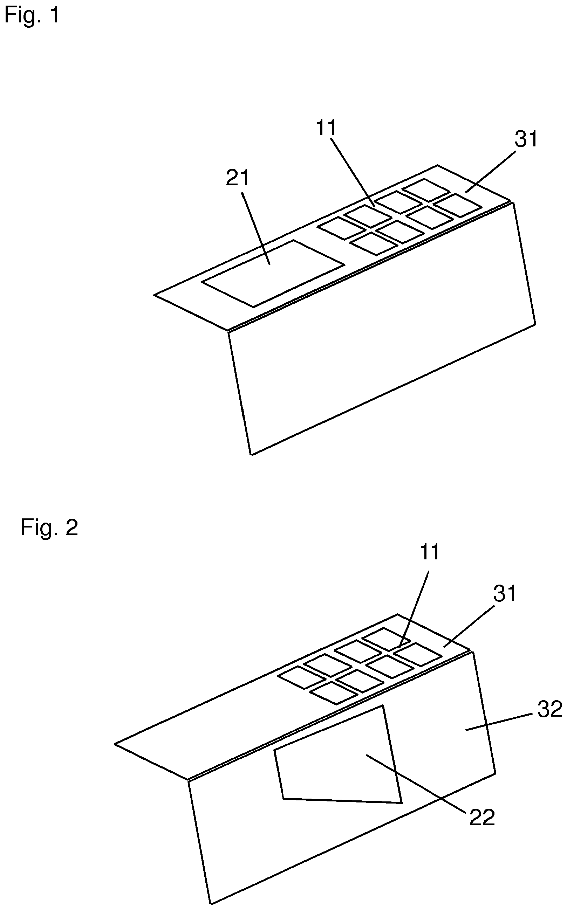

Im Folgenden soll die Erfindung anhand der Zeichnung dargestellt und näher erläutert werden. Die vier Figuren 1 bis 4 zeigen jeweils eine mögliche Ausführung einer erfindungsgemäßen Schaltvorrichtung. Diese dienen beispielhaft zur Steuerung von motorisch verfahrbaren Fenstern in einem Kraftfahrzeug.

Skizzenhaft sind erste und zweite Schaltelemente 11, 13, 21, 22, 23, 24 dargestellt, die als schaltkontaktlose Berührflächensensoren ausgebildet sind. Die Berührflächensensoren können nach verschiedenartigen Sensorprinzipien funktionieren. Vorzugsweise sind sie als kapazitive oder piezoelektrische Sensoren ausgeführt.

Die Berührflächensensoren sind auf Oberflächen angebracht, die an der Innenseite einer fahrerseitigen Kraftfahrzeugtür angeordnet sind. Die Oberflächen werden nachfolgend vereinfachend als Gehäuseflächen 31, 32 bezeichnet. Bei allen hier dargestellten Ausführungen ist beispielhaft eine Bedienung der Berührflächensensoren mit der linken Hand vorgesehen.

Da besonders die Anordnung der Berührflächensensoren zur Erläuterung der Erfindung wesentlich ist, wurde in der Zeichnung auf eine Darstellung weiterer elektrischer und mechanischer Komponenten verzichtet.

Eine übliche Eigenschaft schaltkontaktloser Berührflächensensoren ist, dass diese ohne besonderen Kraftaufwand betätigbar sind. Damit können allerdings auch versehentliche Berührungen leicht Schaltfunktionen auslösen, was beim Schalten von Antriebsorganen zu Sicherheitsproblemen führen kann. Daher ist vorgesehen, dass zum Auslösen einer Schaltfunktion jeweils zugleich ein Berührflächensensor aus einer Gruppe von ersten Schaltelementen 11, 13 und ein Berührflächensensor, der ein zweites Schaltelement 21, 22, 23, 24 ausbildet, betätigt werden müssen. Dabei wird angestrebt, dass die Betätigung eine einfache und komfortable und intuitiv erfassbare Weise erfolgen kann.

Die Figur 1 zeigt eine Schaltvorrichtung, bei der die Berührflächensensoren in Gruppen von ersten und zweiten Schaltelementen 11, 21 an einer gemeinsamen Gehäusefläche 31 angeordnet sind. Die erste Schaltelemente 11 bilden eine matrixartige Anordnung von acht rechteckförmigen Berührflächensensoren, denen die in folgender Tabelle angegebenen Fensterheberfunktionen zugeordnet sind:

| | |
|---|---|
| Fahrerseite vorn aufwärts | Beifahrerseite vorn aufwärts |
| Fahrerseite vorn abwärts | Beifahrerseite vorn abwärts |

| | |
|---|---|
| Fahrerseite hinten aufwärts | Beifahrerseite hinten aufwärts |
| Fahrerseite hinten abwärts | Beifahrerseite hinten abwärts |

Die Funktionen sind dabei auf intuitiv naheliegende Weise angeordnet. So liegen beispielsweise Funktionen der Fahrerseite auf der linken Seite, Funktionen der vorderen Fenster über denen der hinteren Fenster und Funktionen zur Steuerung der Aufwärtsbewegungen der Fenster über denen zur Steuerung von Abwärtsbewegungen.

Als zweites Schaltelement 21 ist ein einziger Berührflächensensor 21 vorgesehen, der neben den ersten Schaltelementen 11 angeordnet ist und eine ähnlich große Fläche belegt, wie alle ersten Schaltelemente 11 zusammen. Dieser zweite Berührflächensensor 21 ist dazu vorgesehen, durch einen darauf abgelegten Handballen der linken Hand betätigt zu werden, während die Betätigung der ersten Schaltelemente 11 mittels der Fingerspitzen erfolgt.

Nur wenn die Betätigung eines ersten Schaltelements 11 und des zweiten Schaltelements 21 zugleich erfolgt, registriert die Schaltvorrichtung dieses als eine gültige Betätigung und löst die entsprechende Schaltfunktion zur Betätigung eines Antriebsorgans aus. Die Betätigung des zweiten Schaltelements 21 dient somit praktisch als eine Freigabe einer durch ein erstes Schaltelement 11 ausgewählten Schaltfunktion. Die versehentliche Auslösung einer Schaltfunktion durch eine unbeabsichtigt erfolgende Berührung ist damit praktisch ausgeschlossen.

Lediglich ein Aufstützen einer Handfläche oder eines Arms könnte zugleich ein erstes wie auch das zweite Schaltelement 11, 21 betätigen. In einem solchen Fall werden aber in der Regel zugleich mehrere erste Schaltelemente 11 betätigt, wodurch eine Fehlbetätigung erkannt und die unbeabsichtigte Auslösung einer Schaltfunktion vermieden werden kann.

Eine diesbezüglich optimierte Ausführung ist in der Figur 2 dargestellt. Deren Funktionsweise entspricht der in der Figur 1 dargestellten Schaltvorrichtung, wobei aber das zweite Schaltelement 22 hier auf eine etwa rechtwinklig abgewinkelte seitlichen Gehäusefläche 32 verlegt ist, wodurch die Möglichkeit einer Schaltauslösung durch Aufstützen einer Hand auf erste und zweite Schaltelemente 11, 22 zugleich hier vollkommen ausgeschlossen ist.

Zur Betätigung des zweiten Schaltelements 22 ist hier nicht der Handballen sondern der Daumen der linken Hand vorgesehen, während die ersten Schaltelemente 11 weiterhin mit den übrigen Fingern der gleichen Hand bedient werden.

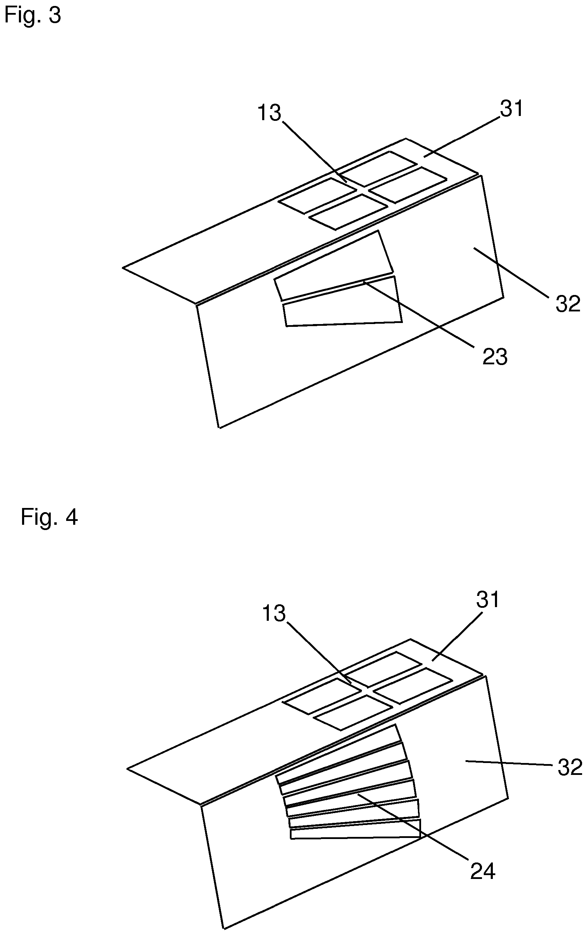

Eine Variante zu dieser Ausführung zeigt die Figur 3. Hier sind, ebenfalls an einer Seitenfläche 32 eines Gehäuses, jetzt speziell zwei zweite Schaltelemente 23 angeordnet, denen, wie in folgender Tabelle dargestellt, die Fensterheberfunktionen "Fenster aufwärts" und "Fenster abwärts" zugeordnet sind.

| |
|---|
| Fenster aufwärts |
| Fenster abwärts |

Durch die Positionierung des Daumens auf einem der beiden zweiten Schaltelemente 23 kann die Bewegungsrichtung des jeweils zu verstellenden Fensters ausgewählt werden. Hieraus ergibt sich der Vorteil, dass die Anzahl der ersten Schaltelemente 13 hier im Vergleich zu den zuvor beschriebenen Ausführungen halbiert werden kann.
Die verbleibenden vier ersten Schaltelemente 13 können etwa die nachfolgend dargestellten Auswahlmöglichkeiten aufweisen:

| | |
|---|---|
| Fahrerseite vorn | Beifahrerseite vorn |
| Fahrerseite hinten | Beifahrerseite hinten |

Unverändert bleibt hier das Erfordernis, dass zum Auslösen einer Schaltfunktion zugleich jeweils ein erstes und ein zweites Schaltelement 13, 23 durch eine Berührung betätigt werden müssen.

In einer weiteren Ausführungsvariante, die die Figur 4 zeigt, ist die Funktionsbelegung der ersten Schaltelemente 13 wie in Figur 3. Die zweiten Schaltelemente 24 bilden hier nun eine Reihe von Betätigungsflächen aus, die es ermöglichen, durch Positionierung eines Daumens ein Fenster in mehrere verschiedene Positionen zu bewegen. Das durch ein erstes Schaltelement 13 ausgewählte Fenster kann so etwa von der ganz geöffneten Stellung über vier Zwischenstellungen bis in die ganz geschlossene Stellung gesteuert werden.

Die nebeneinander angeordneten Betätigungsflächen ermöglichen es der hier nicht dargestellten Elektronik der Schaltvorrichtung zudem, eine wischende Bewegung über die zweiten Schaltelemente 24 hinsichtlich ihrer Richtung und ihrer Geschwindigkeit zu erfassen, um danach die Ansteuerung eines mittels eines ersten Schaltelements 13 ausgewählten Fensters hinsichtlich Richtung und Verfahrgeschwindigkeit zu beeinflussen.

Selbstverständlich können bei allen hier skizzierten Ausführungen über die hier beschriebenen Grundfunktionen hinaus weitere Funktionen in der Schaltvorrichtung implementiert sein, die etwa durch komplexere Bediengesten an den ersten und zweiten Schaltelemente 11, 13, 21, 22, 23, 24 ausgelöst werden können, wie etwa zeitlich kurz hintereinander erfolgende Berührungen bestimmter Schaltelemente 11, 13, 21, 22, 23, 24. Beispielweise kann vorgesehen sein, dass durch Doppeltippen eines ersten oder zweiten Schaltelements, ein Automatiklauf der Fensterverstellung eingeleitet wird.

Vorteilhaft ist es auch, wenn die Schaltvorrichtung wenigsten einen hier nicht dargestellten mechanischen Aktuator aufweist, der im Fall einer gültigen oder gegebenenfalls auch im Fall einer durch die Schaltvorrichtung als nicht gültig bewerteten Eingabe, eine haptische Rückmeldung an den Benutzer generiert.

Besonders vorteilhaft ist es, als erste und/oder zweite Schaltelemente 11, 13, 21, 22, 23, 24 quantitativ kraftsensitive Berührflächensensoren vorzusehen, so dass durch eine erfasste Betätigungskraft unmittelbar die Verfahrgeschwindigkeit eines Fensters beeinflusst werden kann.

### Bezugszeichen

- 11, 13: erste Schaltelemente
- 21, 22, 23, 24: zweite(s) Schaltelement(e)
- 11, 13, 21, 22, 23, 24: Schaltelemente, Berührflächensensoren
- 31, 32: Gehäuseflächen (Oberfläche, Seitenfläche)

## Patentansprüche

1. Schaltvorrichtung zum Schalten von Antriebsorganen in einem Kraftfahrzeug,
aufweisend mehrere erste Schaltelemente (11, 13), die an einer ersten Gehäusefläche (31) angeordnet sind, und durch die zu betätigende Antriebsorgane ausgewählt werden können, und
aufweisend mindestens ein, an der ersten Gehäusefläche (31) oder an einer zweiten Gehäusefläche (32) angeordnetes zweites Schaltelement (21, 22, 23, 24), welches die Funktion des durch ein erstes Schaltelement (11, 13) ausgewählten Antriebsorgans beeinflusst,
wobei die ersten Schaltelemente (11, 13) durch Finger einer Person betätigbar sind,
und wobei das mindestens eine zweite Schaltelement (21, 22, 23, 24) mit einer Handfläche, einem Handballen oder einem Daumen betätigbar ist,
wobei die ersten Schaltelemente (11, 13) und das mindestens eine zweite Schaltelement (21, 22, 23, 24) durch schaltkontaktlose Berührflächensensoren ausgebildet sind, und
wobei
das Einschalten eines Antriebsorgans durch die Betätigung eines der ersten Schaltelemente (11, 13), die gleichzeitige Betätigung eines des mindestens einen zweiten Schaltelements (21, 22, 23, 24) erfordert.

2. Schaltvorrichtung nach Anspruch 1, **dadurch gekennzeichnet, dass** die ersten Schaltelemente (11) und die zweiten Schaltelemente (21) auf der ersten Gehäusefläche (31) parallel zueinander angeordnet sind.

3. Schaltvorrichtung nach Anspruch 1, **dadurch gekennzeichnet, dass** die ersten Schaltelemente (11, 13) auf der ersten Gehäusefläche (31) angeordnet sind und das mindestens eine zweite Schaltelement (22, 23, 24) auf der zweiten Gehäusefläche (32) angeordnet ist, die etwa rechtwinklig zueinander angeordnet sind.

4. Schaltvorrichtung nach Anspruch 1, **dadurch gekennzeichnet, dass** mindestens drei zweite Schaltelemente (24) vorgesehen sind, die nebeneinander angeordnet sind.

5. Schaltvorrichtung nach Anspruch 4, **dadurch gekennzeichnet, dass** bei nacheinander erfolgenden Betätigungen von mehreren nebeneinander angeordneten zweiten Schaltelementen (24) die Betätigungsrichtung und/oder die Betätigungsgeschwindigkeit erfasst wird.

6. Schaltvorrichtung nach Anspruch 1, **dadurch gekennzeichnet, dass** mindesten ein mechanischer Aktuator zur Erzeugung einer Schalthaptik vorgesehen ist.

7. Schaltvorrichtung nach Anspruch 1, **dadurch gekennzeichnet, dass** die ersten Schaltelemente (11, 13) und/oder die zweiten Schaltelemente (21, 22, 23, 24) Betätigungskräfte erfassen können.

## Claims

1. Switching device for switching drive elements in a motor vehicle comprising a plurality of first switching elements (11, 13) which are arranged on a first housing surface (31) and by means of which drive elements to be actuated can be selected, and
having at least one second switching element (21, 22, 23, 24) which is arranged on the first housing surface (31) or on a second housing surface (32) and influences the function of the drive member selected by a first switching element (11, 13),
wherein the first switching elements (11, 13) are operable by fingers of a person,
and wherein the at least one second switching element (21, 22, 23, 24) is operable by a palm, a heel of the hand or a thumb,
wherein the first switching elements (11, 13) and the at least one second switching element (21, 22, 23, 24) are formed by non-switching contact surface sensors, and
wherein switching on a drive member by actuation of one of the first switching elements (11, 13) requires simultaneous actuation of one of the at least one second switching element (21, 22, 23, 24).

2. Switching device according to claim 1, **characterized in that** said first switching elements (11) and said second switching elements (21) are arranged in parallel on said first housing surface (31).

3. Switching device according to claim 1, **characterized in that** the first switching elements (11, 13) are arranged on the first housing surface (31) and the at least one second switching element (22, 23, 24) is arranged on the second housing surface (32), which are arranged approximately at right angles to each other.

4. Switching device according to claim 1, **characterized in that** at least three second switching elements (24) are provided, which are arranged side by side.

5. Switching device according to claim 4, **characterized in that**, in the case of successive actuations of a plurality of second switching elements (24) arranged next to one another, the actuation direction and/or the actuation speed are detected.

6. Switching device according to claim 1, **characterized in that** at least one mechanical actuator is provided for generating a switching haptic.

7. Switching device according to claim 1, **characterized in that** the first switching elements (11, 13) and/or the second switching elements (21, 22, 23, 24) can detect actuation forces.

## Revendications

1. Dispositif de commutation pour la commutation d'éléments d'entraînement dans un véhicule automobile comprenant une pluralité de premiers éléments de commutation (11, 13) qui sont disposés sur une première surface de boîtier (31) et au moyen desquels des éléments d'entraînement à actionner peuvent être sélectionnés, et
avec au moins un deuxième élément de commutation (21, 22, 23, 24) qui est disposé sur la première surface de boîtier (31) ou sur une deuxième surface de boîtier (32) et qui influence la fonction de l'organe d'entraînement sélectionné par un premier élément de commutation (11, 13), où les premiers éléments de commutation (11, 13) sont actionnés par les doigts d'une personne,
et dans lequel le au moins un deuxième élément de commutation (21, 22, 23, 24) est actionnable par une paume, un talon de la main ou un pouce,
dans lequel les premiers éléments de commutation (11, 13) et le au moins un deuxième élément de commutation (21, 22, 23, 24) sont formés par des capteurs à surface de contact non commutables, et dans laquelle la mise en marche d'un organe d'entraînement par l'actionnement d'un des premiers éléments de commutation (11, 13) nécessite l'actionnement simultané d'un des au moins un deuxième élément de commutation (21, 22, 23, 24).

2. Dispositif de commutation selon la revendication 1, **caractérisé en ce que** lesdits premiers éléments de commutation (11) et lesdits seconds éléments de commutation (21) sont disposés en parallèle sur ladite première surface de boîtier (31).

3. Dispositif de commutation selon la revendication 1, **caractérisé en ce que** les premiers éléments de commutation (11, 13) sont disposés sur la première surface de boîtier (31) et le au moins un deuxième élément de commutation (22, 23, 24) est disposé sur la deuxième surface de boîtier (32), qui sont disposés approximativement à angle droit les uns par rapport aux autres.

4. Dispositif de commutation selon la revendication 1, **caractérisé en ce qu'**il est prévu au moins trois seconds éléments de commutation (24), qui sont disposés côte à côte.

5. Dispositif de commutation selon la revendication 4, **caractérisé en ce que**, lors d'actionnements successifs de plusieurs seconds éléments de commutation (24) disposés les uns à côté des autres, le sens d'actionnement et/ou la vitesse d'actionnement sont détectés.

6. Dispositif de commutation selon la revendication 1, **caractérisé en ce qu'**au moins un actionneur mécanique est prévu pour générer une haptique de commutation.

7. Dispositif de commutation selon la revendication 1, **caractérisé en ce que** les premiers éléments de commutation (11, 13) et/ou les seconds éléments de commutation (21, 22, 23, 24) peuvent détecter des forces d'actionnement.
